# EUROPÄISCHE PATENTSCHRIFT

(11) **EP 4 103 885 B1**
(45) Veröffentlichungstag und Bekanntmachung des Hinweises auf die Patenterteilung: **20.03.2024**
(21) Anmeldenummer: 21701312.7
(22) Anmeldetag: 21.01.2021
(51) Int. Cl.: F24C 7/08, G05G 1/08, H03K 17/97, G01D 5/14, H01H 36/00, D06F 34/30, H05B 6/12

(54) **TRAGBARES BEDIENELEMENT MIT RINGMAGNET UND SPEZIFISCHEM MAGNETFELDBEEINFLUSSER, SOWIE BEDIENVORRICHTUNG**
PORTABLE OPERATING ELEMENT HAVING A RING MAGNET AND A SPECIFIC MAGNETIC FIELD INFLUENCER, AS WELL AS AN OPERATING DEVICE
ÉLÉMENT DE COMMANDE PORTATIF COMPRENANT UN AIMANT ANNULAIRE ET UN INFLUENCEUR DE CHAMP MAGNÉTIQUE SPÉCIFIQUE, AINSI QU'UN DISPOSITIF DE COMMANDE

(30) Priorität: 10.02.2020 DE 102020201624
(43) Veröffentlichungstag der Anmeldung: 21.12.2022
(73) Patentinhaber: BSH Hausgeräte GmbH, 81739 München (DE)
(72) Erfinder: WURNITSCH, Ernst, 6382 Kirchdorf in Tirol (AT); REINDL, Michael, 84175 Schalkham (DE); FORSTER, Florian, 83346 Bergen (DE); VORMANN, Ingo, 83278 Traunstein (DE); MARBACH, Andreas, 83374 Traunwalchen (DE)
(86) Internationale Anmeldenummer: PCT/EP2021/051287
(87) Internationale Veröffentlichungsnummer: WO 2021/160398

(56) Entgegenhaltungen:
- EP-A1- 3 477 418
- CN-U- 205 039 104
- CN-U- 208 570 388
- DE-A1-102010 040 675
- DE-A1-102012 001 997

## Beschreibung

Ein Aspekt der Erfindung betrifft ein tragbares Bedienelement für eine Bedienvorrichtung für ein Gargerät. Das Bedienelement ist zum zerstörungsfreien Aufsetzen und Abnehmen auf eine Bedienelementaufnahme der Bedienvorrichtung ausgebildet. Das tragbare Bedienelement ist im aufgesetzten Zustand auf die Bedienelementaufnahme zur Einstellung von Betriebsbedingungen des Gargeräts betätigbar. Das Bedienelement weist ein Gehäuse auf. Es weist darüber hinaus einen Ringmagneten auf, der in dem Gehäuse angeordnet ist. Das Bedienelement weist darüber hinaus einen zum Ringmagneten separaten Magnetfeldbeeinflusser auf. Der Magnetfeldbeeinflusser ist in dem Gehäuse angeordnet. Ein weiterer Aspekt der Erfindung betrifft eine Bedienvorrichtung mit einem derartigen tragbaren Bedienelement.

Eine Bedienvorrichtung mit einem tragbaren Bedienelement gemäß der oben genannten Ausführung ist beispielsweise aus der DE 10 2012 001 997 A1 bekannt. Dort ist vorgesehen, dass an einer Oberseite einer Gebereinheit ein kreisförmiger Flusskonzentrator angeordnet ist. Dieser ist direkt oberhalb eines Ringmagneten positioniert. Dieser flächige scheibenförmige Flusskonzentrator stellt somit eine Kreisscheibenplatte dar. Diese ist einerseits relativ groß und weist in dem Zusammenhang daher ein relativ großes Gewicht auf. Darüber hinaus ist durch diese diesbezügliche geometrische Ausgestaltung die Beeinflussung der Feldlinien des Ringmagneten nur bedingt gezielt möglich. Die Detektion einer Betätigung des tragbaren Bedienelements im Hinblick auf ein Kippen und/oder Drehen ist daher auf Basis dieser Magnetfelddetektion zwar möglich, jedoch im Hinblick auf sehr spezifische und/oder geringfügige Betätigungen nicht ausreichend möglich.

Aus der EP 3 477 418 A1 ist eine Betätigungsvorrichtung bekannt, die eine Betätigungseinheit, einen Positionserfassungsteil und eine Anzeigeeinheit umfasst. Die Betätigungseinheit umfasst dabei ferner ein Betätigungselement und einen beweglichen Lastaufbringungsmechanismus, welcher ein haptisches Feedback ermöglicht.

Die CN 208 570 388 U offenbart ein von einer Platte abnehmbares Bedienelement mit einem Ringmagneten.

Aus der DE 10 2010 040 675 A1 ist ein auf einer Bedienfläche eines Hausgerätes magnetisch gehaltertes Bedienelement bekannt, welches einen sternförmigen Magnetfeldleiter umfasst.

Aus der CN 205 039 104 U ist ein Drehschalter für einen Induktionsherd bekannt, welcher einen Magneten aufweist und auf einer Seite einer Platte des Induktionsherdes angeordnet ist. Auf einer gegenüberliegenden Seite der Platte ist eine Steuerplatine angeordnet, die mit dem Drehschalter zusammenwirkt.

Es ist Aufgabe der vorliegenden Erfindung, ein tragbares Bedienelement sowie eine Bedienvorrichtung zu schaffen, mit welchem beziehungsweise mit welcher die Detektion der Betätigung des Bedienelements auf Basis von Magnetfeldern und Magnetfeldänderungen verbessert ist.

Diese Aufgabe wird durch ein tragbares Bedienelement und eine Bedienvorrichtung gemäß den unabhängigen Ansprüchen gelöst.

Ein Aspekt der Erfindung betrifft ein tragbares Bedienelement für eine Bedienvorrichtung für ein Gargerät. Das tragbare Bedienelement ist zum zerstörungsfreien Aufsetzen und Abnehmen auf einer Bedienelementaufnahme der Bedienvorrichtung ausgebildet. Im aufgesetzten Zustand des tragbaren Bedienelements ist dieses zur Einstellung von Betriebsbedingungen des Gargeräts betätigbar. Das Bedienelement weist ein Gehäuse auf. Das Bedienelement weist darüber hinaus einen Ringmagneten auf, der in dem Gehäuse angeordnet ist. Das Bedienelement weist des Weiteren einen zum Ringmagneten separaten und gegenständlichen Magnetfeldbeeinflusser auf. Dieser Magnetfeldbeeinflusser ist in dem Gehäuse angeordnet. Der Magnetfeldbeeinflusser weist einen Ring auf. Dieser Ring ist oberhalb des Ringmagneten angeordnet. Dieser Ring ist in radialer Richtung des Bedienelements überlappend mit dem Ringmagneten angeordnet. Diesbezüglich wird diese radiale Richtung zu einer Längsachse des tragbaren Bedienelements betrachtet. Der Magnetfeldbeeinflusser weist darüber hinaus zumindest eine Lasche auf. Diese ist an einem Innenrand des Rings angeordnet. Sie ist darüber hinaus axial nach unten stehend orientiert, sodass sie in Richtung einer Längsachse des Bedienelements überlappend mit dem Ringmagneten angeordnet ist. Durch eine derartige spezifische Ausgestaltung eines tragbaren Bedienelements, insbesondere eines Magnetfeldbeeinflussers, kann das Magnetfeld des Ringmagneten dahingehend besser gerichtet werden, dass auch spezifischere und/oder geringfügige Betätigungen des Bedienelements verbessert detektiert werden können. Durch diesen geometrisch spezifizierten Magnetfeldbeeinflusser ist es somit ermöglicht, die Magnetfeldlinien insbesondere des Ringmagneten so zu beeinflussen, dass insbesondere auch spezifische Kippbewegungen des tragbaren Bedienelements detektiert werden können. Insbesondere können diese mit höherer Wahrscheinlichkeit und höherer Genauigkeit erfasst werden. Dies sind insbesondere geringfügige Kippbewegungen aus einer horizontalen Grundstellung des tragbaren Bedienelements heraus. Darüber hinaus können durch eine derartige Ausgestaltung auch Drehbewegungen des tragbaren Bedienelements um seine Längsachse verbessert detektiert werden. Es lassen sich in dem Zusammenhang somit mehrere diskrete Drehstellungen um die Längsachse genauer erfassen. Die Auflösung der einzelnen diskreten Positionen im Hinblick auf eine korrekte Detektion ist dadurch verbessert. Die Anzahl von diskreten Drehstellungen, die mit Betriebsbedingungseinstellungen verknüpft sind und in Umlaufrichtung um die Längsachse ausgebildet sind, kann dadurch im Vergleich zum Stand der Technik erhöht werden. Das Auflösungsvermögen dieser Positionsdetektion ist durch diese Ausgestaltung des tragbaren Bedienelements gemäß dem oben genannten Aspekt verbessert beziehungsweise verfeinert.

Der Magnetfeldbeeinflusser ist somit mit seinem Ring nicht mehr als vollständig durchgehende horizontale Platte ausgebildet. Er ist vielmehr in dem Zusammenhang als Ringform quasi nur mehr im radialen Bereich, in dem auch der Ringmagnet angeordnet ist, vorgesehen. In einer Ausgestaltung als Ring weist er in axialer Richtung, die somit in Richtung der Längsachse orientiert ist, einen dünnen Aufbau auf. Dies bedeutet, dass er in dieser axialen Richtung ein kleineres Ausmaß aufweist, als in radialer Richtung. Der Ring ist somit als Flachring ausgebildet. Dies bedeutet, dass er quasi ein Ringstreifen ist. Dadurch kann in axialer Richtung ein sehr flacher Aufbau ermöglicht werden. Darüber hinaus ist durch die zusätzlichen Laschen eine Ergänzung des Magnetflussbeeinflussers gebildet, welche wesentlich zu dieser individuellen und spezifischeren Magnetfeldbeeinflussung beintragen. Sie sind in einer vorteilhaften Ausführung in einer Vertikalschnittdarstellung senkrecht zu dem Ring orientiert. Diese Lasche ist für sich betrachtet ein separates Teil. Es ist somit kein zusammenhängender geschlossener Laschenring gebildet, der in Umlaufrichtung um die Längsachse ausgebildet wäre. Vielmehr ist durch die zumindest eine Lasche ein Ringsegment gebildet, welches bevorzugt um die Längsachse gekrümmt ist. Darüber hinaus ist diese Lasche in ihrer Querschnittdarstellung so dimensioniert, dass sie in radialer Richtung ein kleineres Ausmaß aufweist, als in axialer Richtung. Dadurch ist hier durch die Lasche auch wiederum in vorteilhafter Weise ein vertikal orientierter Laschenstreifen gebildet. Durch diese Geometrie ist sie quasi in axialer Richtung orientiert. Die Laschen stehen in axialer Richtung betrachtet weiter nach unten, als der Ring. Insbesondere ist vorgesehen, dass an einer Stelle, an welcher der Ring und eine Lasche des Magnetbeeinflussers ausgebildet sind, dieser Magnetfeldbeeinflusser in einer Vertikalschnittdarstellung L-förmig ausgebildet ist. Insbesondere ist an der Stelle mit dem Ring und einer Lasche im Vertikalschnitt ein Winkelteil gebildet. Der Ring und die Lasche sind in dem Zusammenhang in einer vorteilhaften Ausführung in einem Winkel von 85° bis 95°, insbesondere 90°, zueinander orientiert.

Insbesondere ist vorgesehen, dass eine Lasche in radialer Richtung betrachtet und somit senkrecht zur Längsachse betrachtet radial weiter innen positioniert ist, als der Ring. Insbesondere ist vorgesehen, dass ein radial inneres Ende des Rings an der radialen Position ist, an welcher sich eine Lasche in axialer Richtung erstreckt. Insbesondere in axialer Richtung betrachtet ist ein oberes Ende einer Lasche nicht nach oben über den Ring überstehend. Insbesondere endet ein oberes Ende der Lasche an einem radial inneren Ende des Rings.

In einer vorteilhaften Ausführung ist vorgesehen, dass mehrere Laschen vorhanden sind, welche in Umlaufrichtung um die Längsachse betrachtet äquidistant zueinander angeordnet sind. Dadurch wird ein diesbezüglich symmetrisches Muster gebildet, welches in dieser azimutalen Richtung alternierend eine Lasche und dann wiederum einen Freiraum beziehungsweise eine Unterbrechung aufweist. Es wird somit in Umlaufrichtung um die Längsachse ein Laschen-Freiraum-Muster gebildet. Insbesondere ist somit ein Magnetfeldbeeinflusser geschaffen, der bezüglich seiner Ausgestaltung mit den Laschen gezahnt ausgebildet ist.

Durch diese Ausgestaltung der Laschenorientierung und -anordnung kann die Detektion von spezifischen Betätigungen, insbesondere kleineren Kippbewegungen und/oder individuellen Drehbewegungen, verbessert und genauer erfolgen.

Vorzugsweise ist vorgesehen, dass sich die zumindest eine Lasche, insbesondere die mehreren Laschen jeweils, zwischen 20° und 80° in Umlaufrichtung um die Längsachse erstreckt beziehungsweise erstrecken. Dies bedeutet, dass die azimutale Länge einer Lasche über einen Winkelbereich ausgebildet ist, der zwischen 20° und 80° betragen kann.

Insbesondere ist vorgesehen, dass zumindest drei derartige Laschen in Umlaufrichtung um die Längsachse ausgebildet sind. Insbesondere sind vier derartige Laschen in Umlaufrichtung um die Längsachse ausgebildet.

In einer vorteilhaften Ausführung ist vorgesehen, dass der Ring des Magnetfeldbeeinflussers und die zumindest eine Lasche des Magnetfeldbeeinflussers einstückig ausgebildet sind. Dadurch kann die Bauteilzahl reduziert werden. Insbesondere ist es dadurch erreicht, dass die Relativposition zwischen der Lasche und dem Ring stets und dauerhaft beibehalten ist.

Vorzugsweise ist vorgesehen, dass der Magnetfeldbeeinflusser aus einem ferromagnetischen Material ausgebildet ist. Dies ist eine weitere sehr vorteilhafte Ausführung, denn damit kann die spezifische und sehr genaue Beeinflussung des Magnetfelds des Ringmagneten erreicht werden.

In einer vorteilhaften Ausführung ist vorgesehen, dass der Ring des Magnetfeldbeeinflussers auf einer Oberseite des Ringmagneten direkt aufliegt. Es kann auch vorgesehen sein, dass der Ring des Magnetfeldbeeinflussers in radialer Richtung zur Längsachse nach außen über den Ringmagneten übersteht. Insbesondere ist die Oberseite des Ringmagneten durch die Position des Rings vollständig abgedeckt. Die oben genannten Vorteile werden dadurch nochmals verbessert.

Vorzugsweise ist vorgesehen, dass die Laschen des Magnetfeldbeeinflussers in radialer Richtung zur Längsachse weiter innen als der Ringmagnet angeordnet sind und in radialer Richtung beabstandet zum Ringmagneten angeordnet sind. Auch dies ist eine weitere vorteilhafte Ausführung, um die oben genannten Vorteile nochmals zu verbessern.

Vorzugsweise ist vorgesehen, dass sich die Laschen des Magnetfeldbeeinflussers in axialer Richtung weiter nach unten erstrecken, als der Ringmagnet. Auch dadurch wird die Magnetfeldbeeinflussung dahingehend verbessert, dass spezifische Betätigungen des Bedienelements präziser detektiert werden können.

Vorzugsweise ist vorgesehen, dass der Ringmagnet aus einem kunststoffgebundenen Seltenerdenmaterial gespritzt ist oder aus kunststoffgebundenem Hartferrit gespritzt ist. Diese spezifischen Materialien ermöglichen einerseits besonders vorteilhafte Magnetfeldbeeinflussungen. Andererseits lässt sich dadurch eine einfache Herstellung erreichen. Insbesondere ist es somit auch möglich, einen stabilen und möglichst kompakten Ringmagneten bereitzustellen.

Es ist vorgesehen, dass das Gehäuse des tragbaren Bedienelements geschlossen ist. Es weist insbesondere ein Gehäuseoberteil und ein dazu separates Gehäuseunterteil auf.

Die beiden Gehäuseteile können in einer vorteilhaften Ausführung zerstörungsfrei lösbar verbunden sein. Beispielsweise kann hier eine Schraubverbindung oder eine Schnappverbindung oder eine Bajonettverbindung vorgesehen sein. Im geschlossenen Zustand des Gehäuses ist ein Innenraum gebildet, in dem Komponenten angeordnet sind. Insbesondere sind dies der Ringmagnet und der Magnetfeldbeeinflusser.

Es kann vorgesehen sein, dass das tragbare Bedienelement nur das Gehäuse aufweist, in welchem nur zusätzliche Komponenten des tragbaren Bedienelements enthalten sind. Weitere Bauteile, die dem Bedienelement zugehörig sind, sind dann nicht außerhalb des Gehäuses angeordnet. Durch das Gehäuse ist somit die Außengeometrie des tragbaren Bedienelements gebildet. Das tragbare Bedienelement kann scheibenförmig beziehungsweise diskusförmig ausgebildet sein.

In einer alternativen Ausführung ist vorgesehen, dass das tragbare Bedienelement zusätzlich zu dem Gehäuse und den darin angeordneten Komponenten ein weiteres Teilelement aufweist, welches außerhalb des Gehäuses angeordnet ist. Dieses weitere Teilelement kann insbesondere ein Stator sein. Es kann dann vorgesehen sein, dass das Gehäuse mit dem Stator koppelbar ist. Der Stator kann in dem Zusammenhang als Auflagesockel für das Gehäuse ausgebildet sein. Dies bedeutet, dass das Gehäuse auf den Stator aufgesetzt werden kann und relativ zu dem Stator bewegt werden kann. Beispielsweise kann es relativ zu dem Stator gekippt werden und/oder um die Längsachse des Bedienelements, welches die Längsachse des Stators ist, gedreht werden.

Ist das tragbare Bedienelement lediglich durch das Gehäuse als Außenteil gebildet, so kann eine Unterseite des Gehäuses beispielsweise, insbesondere an einem radialen Außenbereich, kegelstumpfförmig ausgebildet sein. Das Gehäuse kann dann mit dem zentralen Bereich der Kegelstumpfform auf eine Bedienelementaufnahme der Bedienvorrichtung aufgesetzt werden. Durch die nach außen folgende Kegelstumpfwand, die dann schräg nach oben geneigt ist und in der Grundposition des tragbaren Bedienelements berührungslos zur Oberseite der Bedienelementaufnahme angeordnet ist, können diesbezüglich auch Kippbewegungen vollzogen werden. Durch eine derartige Kippbewegung kann sich dann diese Mantelwand der Kegelstumpfform zu der Oberseite der Bedienelementaufnahme hin bewegen.

Bei einer Ausführung, bei welcher das Bedienelement zusätzlich zum Gehäuse den außerhalb vom Gehäuse angeordneten Stator aufweist, kann eine derartige Unterseite des Gehäuses an einem radialen Außenbereich der Unterseite auch eben ausgebildet sein. Die Unterseite kann jedoch auch kegelstumpfförmig ausgebildet sein.

Insbesondere ist der Stator so ausgebildet, dass in der aufgesetzten Grundposition des Gehäuses auf dem Stator die Unterseite des Gehäuses nicht auf einer Oberseite der Bedienelementaufnahme der Bedienvorrichtung aufsitzt. Vorzugsweise ist vorgesehen, dass an der Unterseite des Gehäuses eine Vertiefung ausgebildet ist. In diese Vertiefung taucht der Stator ein, wenn das Gehäuse auf dem Stator aufgesetzt ist. Ein Dach der Vertiefung weist einen nach unten orientierten Überstand auf, der in eine Mulde, die in einer Oberseite des Stators ausgebildet ist, eingreift. Damit ist ein verbessertes Auflegen des Gehäuses auf dem Stator ermöglicht. Insbesondere ein seitliches Verrutschen des Gehäuses relativ zum Stator ist dadurch vermieden. Dadurch ist es erreicht, dass die Relativbewegung eines Gehäuses relativ zum Stator sehr präzise und genau durchgeführt werden können. Dadurch können auch entsprechende Betätigungen relativ präzise und genau detektiert werden.

Insbesondere ist vorgesehen, dass bei der Ausführung mit dem Gehäuse und dem Stator zumindest das Gehäuse zerstörungsfrei lösbar vom Stator abgenommen werden kann. Es kann vorgesehen sein, dass der Stator ortsfest an der Bedienelementaufnahme der Bedienvorrichtung verbaut ist. Es kann jedoch auch vorgesehen sein, dass auch der Stator zerstörungsfrei lösbar von der Bedienelementaufnahme abgenommen werden kann.

In einer vorteilhaften Ausführung ist vorgesehen, dass der Überstand kegelstumpfförmig ausgebildet ist. Zusätzlich oder anstatt dazu kann vorgesehen sein, dass die Mulde als kegelstumpfförmige Vertiefung ausgebildet ist. Dadurch werden die oben genannten Vorteile bezüglich der sicheren Positionierung verbessert. Insbesondere ist es darüber hinaus jedoch ermöglicht, dass eine leichtgängige und präzise Relativbewegung des Gehäuses relativ zum Stator ermöglicht ist. Insbesondere Drehbewegungen und Kippbewegungen können dadurch besonders präzise durchgeführt werden.

Ein weiterer Aspekt der Erfindung betrifft eine Bedienvorrichtung für ein Gargerät. Die Bedienvorrichtung weist eine Bedienelementaufnahme auf. Die Bedienvorrichtung weist darüber hinaus zumindest ein tragbares Bedienelement auf, welches gemäß dem oben genannten Aspekt ausgebildet ist oder gemäß einer vorteilhaften Ausführung davon ausgebildet ist. Das tragbare Bedienelement ist zumindest in Teilkomponenten zerstörungsfrei lösbar auf der Bedienelementaufnahme aufsetzbar und abnehmbar. Dies betrifft insbesondere das Gehäuse des Bedienelements mit den darin enthaltenen Komponenten.

Ein weiterer Aspekt der Erfindung betrifft ein Haushaltsgerät mit einer derartigen Bedienvorrichtung. Das Haushaltsgerät kann zum Zubereiten von Lebensmitteln ausgebildet sein. Insbesondere ist es ein Gargerät. Es kann beispielsweise ein Kochfeld oder ein Backofen sein.

Weitere Merkmale der Erfindung ergeben sich aus den Ansprüchen, den Figuren und der Figurenbeschreibung.

Ausführungsbeispiele der Erfindung werden nachfolgend anhand schematischer Zeichnungen näher erläutert. Es zeigen:
- Fig. 1: eine perspektivische Darstellung eines Ausführungsbeispiels eines Gargeräts;
- Fig. 2: eine Vertikalschnittdarstellung durch ein Ausführungsbeispiel einer erfindungsgemäßen Bedienvorrichtung mit einem Ausführungsbeispiel eines erfindungsgemäßen tragbaren Bedienelements;
- Fig. 3: eine separierte Darstellung eines Bedienelements gemäß einem Ausführungsbeispiel; und
- Fig. 4: eine Explosionsdarstellung von Teilkomponenten des tragbaren Bedienelements gemäß Fig. 2 und Fig. 3.

In den Figuren werden gleiche oder funktionsgleiche Elemente mit den gleichen Bezugszeichen versehen.

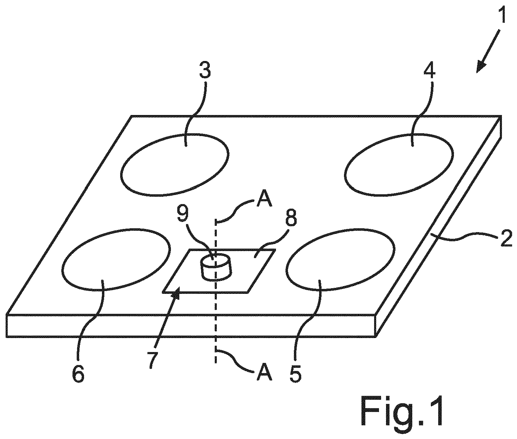

In Fig. 1 ist eine vereinfachte Darstellung eines Gargeräts gezeigt, welches hier ein Kochfeld 1 ist. Das Kochfeld 1 weist eine Kochfeldplatte 2 auf, auf welcher in Position, Anzahl und geometrischer Ausgestaltung lediglich beispielhaft zu verstehen Kochzonen 3, 4, 5 und 6 dargestellt sind. Das Kochfeld 1 weist darüber hinaus eine Bedienvorrichtung 7 auf. Die Bedienvorrichtung 7 weist eine Bedienelementaufnahme 8 und ein dazu separates tragbares Bedienelement 9 auf. Das Bedienelement 9 ist hier flachzylinderartig beziehungsweise diskusartig ausgebildet. Es ist zerstörungsfrei lösbar auf der Bedienelementaufnahme 8 abnehmbar und wieder aufsetzbar. Im aufgesetzten Zustand des Bedienelements 9 auf der Bedienelementaufnahme 8 können Betriebsbedingungen des Kochfelds 1 eingestellt werden. Beispielsweise kann hier eine Kochzone 3 bis 6 ausgewählt werden und/oder eine Kochstufe einer ausgewählten Kochzone 3 bis 6 eingestellt werden.

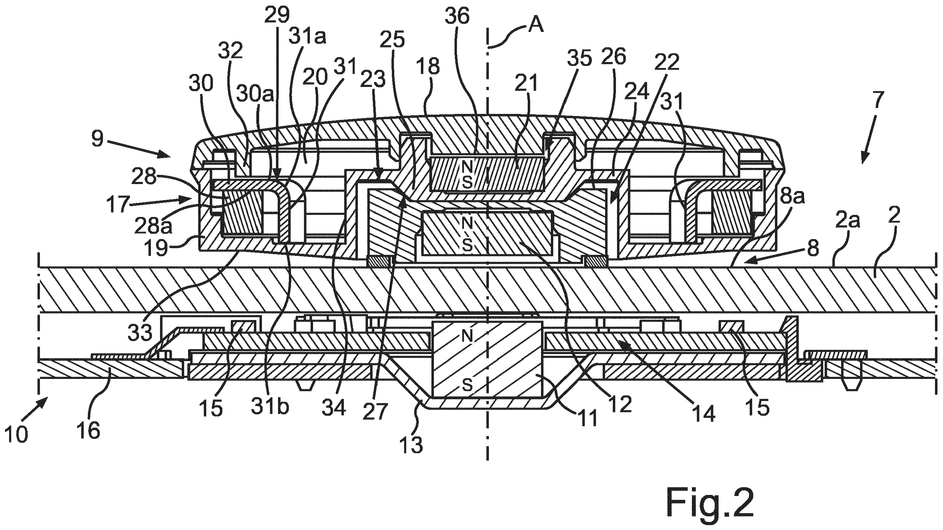

In Fig. 2 ist in einer Vertikalschnittdarstellung ein Ausführungsbeispiel der Bedienvorrichtung 7 gezeigt. Das tragbare Bedienelement 9 ist hier in einer Grundposition auf der Bedienelementaufnahme 8 angeordnet. Die Bedienelementaufnahme 8 kann Bestandteil der Kochfeldplatte 2 sein. Anstelle der Kochfeldplatte 2 kann bei einem anderen Gargerät beispielsweise eine Bedienblende einer Bedienvorrichtung diese Bedienelementaufnahme 8 aufweisen.

Die Bedienvorrichtung 7 weist eine Detektoreinheit 10 auf. Die Detektoreinheit 10 ist unterhalb der Kochfeldplatte 2 angeordnet. Die Detektoreinheit 10 weist einen Magneten 11 auf. Dieser ist als Haltemagnet ausgebildet. Dies bedeutet, dass er in Wechselwirkung mit einem Magneten 12 des tragbaren Bedienelements 9 durch magnetische Haltekraft die Position des tragbaren Bedienelements 9 auf der Bedienelementaufnahme 8 hält. Der Magnet 12 ist somit ein Haltemagnet.

Darüber hinaus weist die Detektoreinheit 10 eine Rückschlussplatte 13 auf. Diese ist insbesondere als Rückschlussblech ausgebildet. Sie ist insbesondere ferromagnetisch ausgebildet. Darüber hinaus weist die Detektoreinheit 10 eine Platine 14 auf. Auf dieser sind elektronische Komponenten angeordnet. Diese Platine 14 weist Sensoren auf, um in Wechselwirkung mit Komponenten des tragbaren Bedienelements 9 die Betätigung des tragbaren Bedienelements 9 erfassen zu können. Insbesondere sind auf dieser Platine 14 auch Sensoren 15 angeordnet. Diese sind insbesondere Hall-Sensoren.

Darüber hinaus weist in dem Ausführungsbeispiel diese Detektoreinheit 10 eine Hauptplatine 16 auf. Diese Hauptplatine 16 weist Anzeigeelemente auf. Sie ist auch mit der Platine 14, die auch als Sensorplatine bezeichnet werden kann, elektronisch verbunden.

Die Bedienvorrichtung 7 weist eine Längsachse A auf. Diese ist senkrecht zur Bedienelementaufnahme 8 orientiert. Wie in dem Ausführungsbeispiel zu erkennen ist, ist der Haltemagnet 11 in Richtung dieser Längsachse A und somit axial polarisiert. Im Ausführungsbeispiel ist der Nordpol N oben und der Südpol S unten. Der Magnet 12, der zum Halten vorgesehen ist, ist entsprechend axial magnetisiert. Es sind der Südpol S unten und der Nordpol N oben.

Das tragbare Bedienelement 9 weist im gezeigten Ausführungsbeispiel ein Gehäuse 17 auf. Das Gehäuse 17 weist ein Gehäuseoberteil 18 auf. Es weist darüber hinaus ein dazu separates Gehäuseunterteil 19 auf. Die Gehäuseteile 18 und 19 sind miteinander verbunden. Insbesondere ist eine zerstörungsfrei lösbare Verbindung vorgesehen. Durch die beiden Gehäuseteile 18 und 19 ist das Gehäuse 17 vollständig geschlossen. Es wird dadurch ein Innenraum 20 in dem Gehäuse 17 gebildet. In dem Innenraum 20 sind weitere Komponenten des tragbaren Bedienelements 9 angeordnet. Insbesondere ist in dem Gehäuse 17 ein weiterer Magnet 21 angeordnet. Dieser ist ebenso zentral positioniert, wie der Magnet 12. Die Magnete 12 und 21 treten in magnetische Wechselwirkung. Dadurch wird eine magnetische Haltekraft aufgebaut. Das Gehäuse 17 sitzt in dem Zusammenhang auf einem weiteren Teilelement 22 des tragbaren Bedienelements 9 auf. Dieses Teilelement 22 ist im Ausführungsbeispiel ein Stator. Er ist separat zum Gehäuse 17 und außerhalb des Gehäuses 17 angeordnet. Insbesondere ist er direkt auf der Oberseite 2a der Kochfeldplatte 2 angeordnet. Insbesondere ist er direkt auf einer Oberseite 8a der Bedienelementaufnahme 8 angeordnet. Das Gehäuse 17 ist in diesem Ausführungsbeispiel direkt auf diesem Teilelement 22 aufliegend beziehungsweise aufsitzend angeordnet. Durch die Magnete 12 und 21 ist hier eine magnetische Haltekraft erzeugt, sodass das Gehäuse 17 magnetisch gehalten auf dem Teilelement 22 aufsitzt. Auch der Magnet 21 ist axial magnetisiert. In dem Ausführungsbeispiel ist der Nordpol N oben und der Südpol S unten. Das Gehäuse 17 ist in dem Zusammenhang so gebildet, dass es an der Unterseite, die im Ausführungsbeispiel durch das Gehäuseunterteil 19 gebildet ist, eine Vertiefung 23 aufweist. In diese Vertiefung 23 taucht das Teilelement 22 ein. Wie zu erkennen ist, ist an einem Dach 24, welches die Vertiefung 23 nach oben hin begrenzt, ein nach unten ausgebildeter Überstand 25 angeformt. Dieser Überstand 25 ist insbesondere kegelstumpfförmig ausgebildet. Im Ausführungsbeispiel ist vorgesehen, dass an einer Oberseite 26 des Teilelements 22 eine Mulde 27 ausgebildet ist. Diese Mulde 27 ist vorzugsweise kegelstumpfförmig ausgebildet. Insbesondere sind hier vorzugswiese komplementäre geometrische Ausgestaltungen zwischen dem Überstand 25 und der Mulde 27 gebildet.

Das Gehäuseoberteil 18, welches auch als Kappe bezeichnet werden kann, ist vorzugsweise aus einem ferromagnetischen Material ausgebildet.

Insbesondere ist in dem Gehäuse 17 ein umlaufend geschlossener Ringmagnet 28 angeordnet. Der Ringmagnet 28 ist im Ausführungsbeispiel vorzugsweise axial magnetisiert. Sein Südpol S ist hier oben und sein Nordpol N unten. Dieser in Umlaufrichtung um die Längsachse A vollständig geschlossene Ringmagnet 28 ist in seinem radialen Ausmaß so angeordnet, dass in der gezeigten Grundstellung beziehungsweise Grundposition des tragbaren Bedienelements 9 dieser Ringmagnet 28 in axialer Richtung quasi oberhalb der Hall-Sensoren 15 positioniert ist.

Das tragbare Bedienelement 9 weist darüber hinaus einen Magnetfeldbeeinflusser 29 auf. Dieser ist ein zum Ringmagneten 28 separates Bauteil. Vorzugsweise ist dieser Magnetfeldbeeinflusser 29 aus einem ferromagnetischen Material ausgebildet. Der Magnetfeldbeeinflusser 29 ist vollständig im Inneren 20 angeordnet. Der Magnetfeldbeeinflusser 29 weist einen Ring 30 auf. Dieser Ring 30 ist so positioniert, dass er in radialer Richtung zur Längsachse A eine Oberseite 28a des Ringmagneten 28 von oben vollständig abdeckt. Der Ring 30, der relativ flachbauend ausgebildet ist, ist in Umlaufrichtung um die Längsachse A unterbrechungsfrei ausgebildet. Er erstreckt sich in radialer Richtung zur Längsachse A radial etwas weiter nach außen als der Ringmagnet 28. Darüber hinaus erstreckt er sich in radialer Richtung etwas weiter nach innen als der Ringmagnet 28. Der Magnetfeldbeeinflusser 29 weist darüber hinaus mehrere Laschen 31 auf. Es sind zumindest zwei Laschen 31 ausgebildet, die in Umlaufrichtung um die Längsachse A an dem Ring 30 ausgebildet sind. Sie sind in Umlaufrichtung um die Längsachse A als Ringabschnitte gebildet und laufen somit nicht vollständig um. Sie sind in Umlaufrichtung um die Längsachse A äquidistant zueinander angeordnet. Es können mehr als zwei derartige Laschen 31 vorgesehen sein, beispielsweise drei oder vier oder auch mehr als vier.

Die Laschen 31 sind einstückig mit dem Ring 30 ausgebildet. Die Laschen 31 sind in der Vertikalschnittdarstellung gemäß Fig. 2 nicht horizontal orientiert, sondern vertikal orientiert. Diese Orientierung ist insbesondere auch in Bezug zur Haupterstreckung des Rings 30 zu sehen. In der Vertikalschnittdarstellung ist der Magnetfeldbeeinflusser 29 an dieser Stelle, an welcher der Ring 30 und eine Lasche 31 vorhanden sind, L-förmig ausgebildet. Die beiden Schenkel dieser L-Form werden durch den Ring 30 einerseits und durch die Lasche 31 andererseits gebildet. Die Lasche 31 erstreckt sich ausgehend von einem oberen Ende 31a axial nach unten. Ein unteres Ende 31b der Lasche 31 erstreckt sich im Ausführungsbeispiel weiter nach unten als der Ringmagnet 28. Wie zu erkennen ist, ist die Lasche 31 in radialer Richtung zur Längsachse A weiter innen positioniert als der Ringmagnet 28. Insbesondere ist vorgesehen, dass in dieser radialen Richtung ein Abstand zwischen dem Ringmagnet 28 und der Lasche 31 ausgebildet ist. Die Lasche 31 steht in axialer Richtung nicht nach oben gegenüber dem Ring 30 über. Ein Übergang zwischen dem Ring 30, insbesondere einem radial inneren Ende beziehungsweise einem Innenrand 30a des Rings 30, und einer Lasche 31 ist insbesondere abgerundet ausgebildet.

Insbesondere ist vorgesehen, dass an einer Innenseite 18a des Gehäuseoberteils 18 ein Axialsteg 32 ausgebildet ist. Der Axialsteg 32 ist in radialer Richtung zur Längsachse A betrachtet an einer Position, an welcher der Ring 30 angeordnet ist. Insbesondere sitzt dieser Axialsteg 32 von oben auf dem Ring 30 auf. Insbesondere ist der Steg 32 aus einem ferromagnetischen Material ausgebildet. Insbesondere ist der Steg 32 umlaufend um die Längsachse A ausgebildet, insbesondere unterbrechungsfrei ausgebildet. Er ist somit in Umlaufrichtung um die Längsachse A vollständig geschlossen ausgebildet.

In dieser Grundstellung und in der in Fig. 2 gezeigten Ausführung des tragbaren Bedienelements 9 kann eine Unterseite 33 des tragbaren Bedienelements 9 eben ausgebildet sein. Dies betrifft die Fläche, welche außerhalb der Vertiefung 23 gebildet ist. Es kann jedoch auch, wie dies in Fig. 2 gezeigt ist, eine leichte Schrägstellung ausgebildet sein. Es kann vorgesehen sein, dass diese Schrägstellung von einer radial inneren Position zu einer radial äußeren Position nach oben orientiert ist.

Insbesondere kann dadurch eine Kippbewegung des Gehäuses 17 relativ zum Teilelement 22 einfach vollzogen werden. Insbesondere trägt dazu auch die spezifische Form der Lagerung des Gehäuses 17 auf dem Teilelement 22 bei.

Zur Betriebsbedingungseinstellung des Kochfelds 1 kann einerseits ein Kippen des Gehäuses 17 durchgeführt werden. Diese Kippbewegung wird durch die Hallsensoren 15 detektiert. Es reduziert sich in dem Zusammenhang an einer Stelle der axiale Abstand zwischen einem Ringmagneten 28 und dem Magnetfeldbeeinflusser 29 zu den insbesondere Hallsensoren 15, wohingegen sich an der gegenüberliegenden Seite dieser axiale Abstand vergrößert.

Zusätzlich ist es auch möglich, dass das Gehäuse 17 um die Längsachse A gedreht wird, um die Betriebsbedingungen des Kochfelds 1 einzustellen. Beispielsweise kann durch eine Kippbewegung eine Kochzone 3 bis 6 ausgewählt werden und durch eine Drehbewegung um die Längsachse A eine Kochstufe der ausgewählten Kochzone 3 bis 6 eingestellt werden.

Insbesondere ist es vorgesehen, dass das Gehäuse 17 relativ zu dem Teilelement 22 gedreht werden kann. Das Gehäuse 17 ist im Ausführungsbeispiel zerstörungsfrei lösbar von dem Teilelement 22 abnehmbar und wieder aufsetzbar.

Es kann vorgesehen sein, dass in einem weiteren Ausführungsbeispiel das tragbare Bedienelement 9 lediglich durch das Gehäuse 17 gebildet ist. Es weist dann kein externes Teilelement 22 auf. Bei einem derartigen Ausführungsbeispiel ist das Gehäuseunterteil 19 nicht mit einer Vertiefung 23 ausgebildet. Vielmehr ist dann in dieser zentralen mittigen Zone eine ebene Wand gebildet, die direkt auf der Oberseite 8a aufsitzt.

Wie zu erkennen ist, erstreckt sich bei dem gezeigten Ausführungsbeispiel die Vertiefung 23 in axialer Richtung in einer Höhe, die zumindest teilweise der Höhe des Magnetfeldbeeinflusser 29, insbesondere der Lasche 31, entspricht. In axialer Richtung ist somit diese Vertiefung 23 zumindest bereichsweise überlappend mit dem Magnetfeldbeeinflusser 29 angeordnet. Im Ausführungsbeispiel erstreckt sich eine Seitenwand 34, die die Vertiefung 23 begrenzt, vollständig überlappend mit der gesamten Höhe des Magnetfeldbeeinflussers 29. Insbesondere erstreckt sich diese Seitenwand 34 noch weiter nach oben, als der Ring 30. In radialer Richtung ist diese Seitenwand 34 beabstandet zu dem Magnetfeldbeeinflusser 29, insbesondere der Lasche 31 angeordnet. Der Magnet 21 in dem Gehäuse 17 sitzt in einer Aufnahme 35 des Gehäuseunterteils 19, die nach oben hin offen ist. In diese taucht ein nach unten überstehender Überstand 36 der Kappe beziehungsweise des Gehäuseoberteils 18 ein.

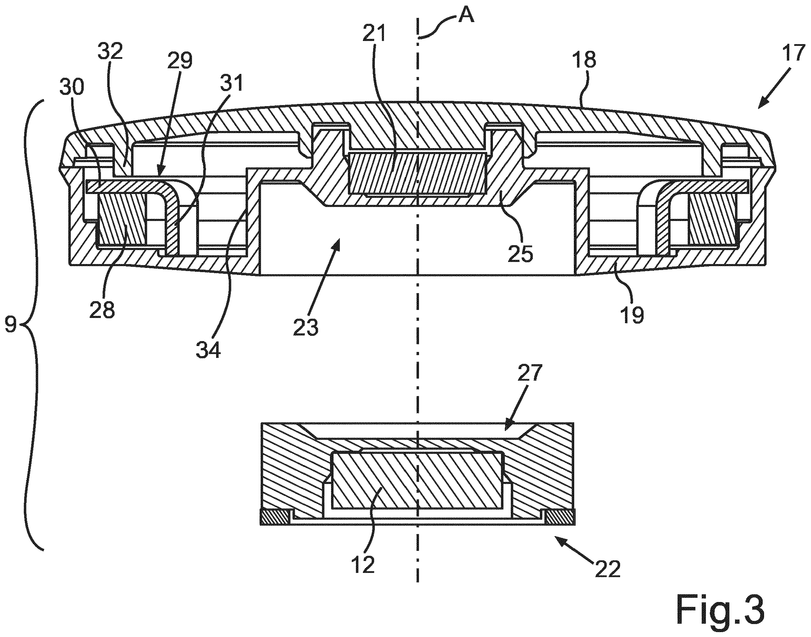

In Fig. 3 ist das Ausführungsbeispiel des tragbaren Bedienelements 9 in einer separierten Darstellung gezeigt.

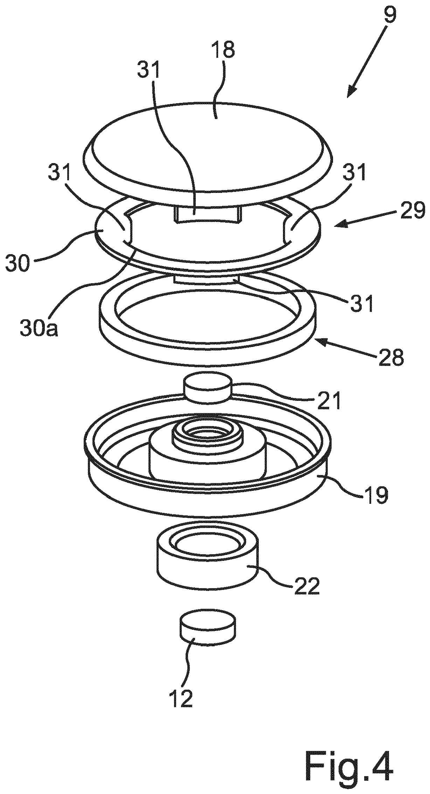

In Fig. 4 ist das Ausführungsbeispiel des tragbaren Bedienelements 9 in einer Explosionsdarstellung gezeigt. Im gezeigten Ausführungsbeispiel sind hier vier Laschen 31 ausgebildet.

Bei dem in Fig. 2 bis 4 gezeigten Ausführungsbeispiel des tragbaren Bedienelements 9 kann das Gehäuse 17 als Rotorbaugruppe und das Teilelement 22 als Statorbaugruppe bezeichnet werden. Das Gehäuse 17 kann im aufgesetzten Zustand auf das Teilelement 22 relativ zum Teilelement 22 bewegt werden, insbesondere zur Längsachse A geneigt beziehungsweise gekippt werden und/oder um die Längsachse A gedreht werden.

Durch das erläuterte tragbare Bedienelement 9 können kleinere Kippwinkel detektiert werden, als bisher. Darüber hinaus kann auch die Drehbewegung viel genauer aufgelöst werden, was bedeutet, dass mit dieser Ausführungsform noch mehr Stufen und somit diskrete Drehstellungen um die Längsachse A realisiert werden können. Darüber hinaus kann das tragbare Bedienelement 9 für unterschiedliche Haushaltsgeräte genutzt werden. Beispielsweise für ein Kochfeld und einen Backofen und einen Kaffeevollautomaten. Diese konkrete Aufzählung von Haushaltsgeräten ist nicht abschließend zu verstehen und nur beispielhaft. Es können auch vielfältigste andere Haushaltsgeräte wie beispielsweise ein Haushaltsgerät zur Pflege von Wäschestücken, wie eine Waschmaschine, ein Wäschetrockner oder ein Waschtrockner, vorgesehen sein. Ebenso kann ein anderes Haushaltsgerät, beispielsweise zum Reinigen von Geschirr oder zum Lagern und Konservieren von Lebensmitteln wie beispielsweise ein Kühlschrank oder ein Gefriergerät oder ein Kühl-Gefrier-Kombigerät vorgesehen sein. Auch andere Haushaltsgeräte, wie eine Fritteuse oder ein Dunstabzug oder dergleichen, können diesbezüglich vorgesehen sein.

### Bezugszeichenliste

- 1: Kochfeld
- 2: Kochfeldplatte
- 2a: Oberseite
- 3: Kochzone
- 4: Kochzone
- 5: Kochzone
- 6: Kochzone
- 7: Bedienvorrichtung
- 8: Bedienelementaufnahme
- 8a: Oberseite
- 9: Bedienelement
- 10: Detektoreinheit
- 11: Magnet
- 12: Magnet
- 13: Rückschlussplatte
- 14: Platine
- 15: Sensor
- 16: Hauptplatine
- 17: Gehäuse
- 18: Gehäuseoberteil
- 18a: Innenseite
- 19: Gehäuseunterteil
- 20: Innenraum
- 21: Magnet
- 22: Teilelement
- 23: Vertiefung
- 24: Dach
- 25: Überstand
- 26: Oberseite
- 27: Mulde
- 28: Ringmagnet
- 28a: Oberseite
- 29: Magnetfeldbeeinflusser
- 30: Ring
- 30a: Innenrand
- 31: Lasche
- 31a: oberes Ende
- 31b: unteres Ende
- 32: Axialsteg/Unterseite
- 33: Unterseite
- 34: Seitenwand
- 35: Aufnahme
- 36: Überstand
- 37: Element
- A: Längsachse
- N: Nordpol
- S: Südpol

## Patentansprüche

1. Tragbares Bedienelement (9) für eine Bedienvorrichtung (7) für ein Gargerät (1), welches zum zerstörungsfreien Aufsetzen und Abnehmen auf eine Bedienelementaufnahme (8) der Bedienvorrichtung (7) ausgebildet ist, und im aufgesetzten Zustand zur Einstellung von Betriebsbedingungen des Gargeräts (1) betätigbar ist, wobei das Bedienelement (9) ein Gehäuse (17) und einen Ringmagnet (28) aufweist, der in dem Gehäuse (17) angeordnet ist, und das Bedienelement (9) einen zum Ringmagnet (28) separaten Magnetfeldbeeinflusser (29) aufweist, der in dem Gehäuse (17) angeordnet ist, wobei der Magnetfeldbeeinflusser (29) einen Ring (30) aufweist, der oberhalb dem Ringmagnet (28) angeordnet ist und in radialer Richtung des Bedienelements (9) überlappend mit dem Ringmagnet (28) angeordnet ist, **dadurch gekennzeichnet, dass** der Magnetfeldbeeinflusser (29) zusätzlich zumindest eine Lasche (31) aufweist, die an einem Innenrand (30a) des Rings (30) angeordnet ist und axial nach unten stehend orientiert ist, so dass sie in Richtung einer Längsachse (A) des Bedienelements (9) überlappend mit dem Ringmagnet (28) angeordnet ist.

2. Tragbares Bedienelement (9) nach Anspruch 1, **dadurch gekennzeichnet, dass** mehrere Laschen (31) vorhanden sind, die in Umlaufrichtung um die Längsachse (A) äquidistant angeordnet sind.

3. Tragbares Bedienelement (9) nach Anspruch 2, **dadurch gekennzeichnet, dass** sich die Laschen (31) jeweils zwischen 20° und 80° in Umlaufrichtung um die Längsachse (A) erstrecken.

4. Tragbares Bedienelement (9) nach einem der vorhergehenden Ansprüche, **dadurch gekennzeichnet, dass** der Ring (30) und die zumindest eine Lasche (31) einstückig ausgebildet sind.

5. Tragbares Bedienelement (9) nach einem der vorhergehenden Ansprüche, **dadurch gekennzeichnet, dass** der Magnetfeldbeeinflusser (29) aus einem ferromagnetischen Material ist.

6. Tragbares Bedienelement (9) nach einem der vorhergehenden Ansprüche, **dadurch gekennzeichnet, dass** der Ring (30) auf einer Oberseite (28a) des Ringmagneten (28) direkt aufliegt und/oder der Ring (30) in radialer Richtung zur Längsachse (A) nach außen über den Ringmagnet (28) übersteht.

7. Tragbares Bedienelement (9) nach einem der vorhergehenden Ansprüche, **dadurch gekennzeichnet, dass** die zumindest eine Lasche (31) in radialer Richtung zur Längsachse (A) weiter innen als der Ringmagnet (28) angeordnet ist und in radialer Richtung beabstandet zum Ringmagnet (28) angeordnet ist.

8. Tragbares Bedienelement (9) nach einem der vorhergehenden Ansprüche, **dadurch gekennzeichnet, dass** sich die zumindest eine Lasche (31) in axialer Richtung weiter nach unten erstreckt, als der Ringmagnet (28).

9. Tragbares Bedienelement (9) nach einem der vorhergehenden Ansprüche, **dadurch gekennzeichnet, dass** der Ringmagnet (28) aus einem kunststoffgebundenen Seltenerdenmaterial gespritzt ist oder aus kunststoffgebundenen Hartferrit gespritzt ist.

10. Tragbares Bedienelement (9) nach einem der vorhergehenden Ansprüche, **dadurch gekennzeichnet, dass** das Gehäuse (17) geschlossen ist und ein Gehäuseoberteil (18) und ein Gehäuseunterteil (19) aufweist.

11. Tragbares Bedienelement (9) nach einem der vorhergehenden Ansprüche, **dadurch gekennzeichnet, dass** das Gehäuse (17) eine Unterseite (33) aufweist, welche bereichsweise, insbesondere an einem radialen Außenbereich, kegelstumpfförmig ausgebildet ist.

12. Tragbares Bedienelement (9) nach einem der vorhergehenden Ansprüche, **dadurch gekennzeichnet, dass** das Bedienelement (9) das Gehäuse (17) aufweist und ein zum Gehäuse (17) separates Teilelement (22) aufweist, auf dem das Gehäuse (17) aufgesetzt ist und auf welchem das Gehäuse (17) relativ zum Teilelement (22) bewegbar ist.

13. Tragbares Bedienelement (9) nach Anspruch 12, **dadurch gekennzeichnet, dass** das Gehäuse (17) an der Unterseite (33) eine Vertiefung (23) aufweist, in welche das Teilelement (22) eintaucht, wobei ein Dach (24) der Vertiefung (23) einen Überstand (25) aufweist, der in eine Mulde (27) in einer Oberseite (26) des Teilelements (22) eingreift.

14. Tragbares Bedienelement (9) nach Anspruch 13, **dadurch gekennzeichnet, dass** der Überstand (25) kegelstumpfförmig ausgebildet ist und/oder die Mulde (27) als zylinderstumpfförmige Vertiefung ausgebildet ist.

15. Bedienvorrichtung (7) für ein Gargerät (1), mit einer Bedienelementaufnahme (8) und einem tragbaren Bedienelement (9) nach einem der vorhergehenden Ansprüche, welches zerstörungsfrei lösbar auf die Bedienelementaufnahme (8) aufsetzbar und abnehmbar ist.

## Claims

1. Portable operating element (9) for an operating apparatus (7) for a cooking appliance (1), which is embodied for the non-destructive positioning on and removal from an operating element receptacle (8) of the operating apparatus (7), and in the positioned state can be actuated to set operating conditions of the cooking appliance (1), wherein the operating element (9) has a housing (17) and an annular magnet (28), which is arranged in the housing (17), and the operating element (9) has a magnetic field influencer (29) which is separate from the annular magnet (28) and is arranged in the housing (17), wherein the magnetic field influencer (29) has a ring (30), which is arranged above the annular magnet (28) and is arranged so as to overlap with the annular magnet (28) in the radial direction of the operating element (9), **characterised in that** the magnetic field influencer (29) additionally has at least one lug (31), which is arranged on an inner edge (30a) of the ring (30) and is oriented vertically axially downwards so that it is arranged in the direction of a longitudinal axis (A) of the operating element (9) so as to overlap with the annular magnet (28).

2. Portable operating element (9) according to claim 1, **characterised in that** a number of lugs (31) are present, which are arranged equidistantly in the peripheral direction about the longitudinal axis (A).

3. Portable operating element (9) according to claim 2, **characterised in that** the lugs (31) extend in each case between 20° and 80° in the peripheral direction about the longitudinal axis (A).

4. Portable operating element (9) according to one of the preceding claims, **characterised in that** the ring (30) and the at least one lug (31) are embodied in one piece.

5. Portable operating element (9) according to one of the preceding claims, **characterised in that** the magnetic field influencer (29) is made from a ferromagnetic material.

6. Portable operating element (9) according to one of the preceding claims, **characterised in that** the ring (30) rests directly on a top side (28a) of the annular magnet (28) and/or in the radial direction with respect to the longitudinal axis (A), the ring (30) projects outwards beyond the annular magnet (28).

7. Portable operating element (9) according to one of the preceding claims, **characterised in that** in the radial direction with respect to the longitudinal axis (A), the at least one lug (31) is arranged further inwards than the annular magnet (28) and in the radial direction is arranged at a distance from the annular magnet (28).

8. Portable operating element (9) according to one of the preceding claims, **characterised in that** in the axial direction the at least one lug (31) extends further downwards than the annular magnet (29).

9. Portable operating element (9) according to one of the preceding claims, **characterised in that** the annular magnet (28) is injection moulded from a plastic-bonded rare earth material or from plastic-bonded hard ferrite.

10. Portable operating element (9) according to one of the preceding claims, **characterised in that** the housing (17) is closed and has a housing upper part (18) and a housing lower part (19).

11. Portable operating element (9) according to one of the preceding claims, **characterised in that** the housing (17) has a lower side (33), which is embodied in the form of a truncated cone in areas, in particular on a radial outer area.

12. Portable operating element (9) according to one of the preceding claims, **characterised in that** the operating element (9) has the housing (17), and a subelement (22) which is separate from the housing (17), on which the housing (17) is positioned and on which the housing (17) can be moved relative to the subelement (22).

13. Portable operating element (9) according to claim 12, **characterised in that** the housing (17) has a depression (23) on the underside (33), in which the subelement (22) immerses, wherein a roof (24) of the depression (23) has an overlap (25) which engages in a cavity (27) in a top side (26) of the subelement (22).

14. Portable operating element (9) according to claim 13, **characterised in that** the overlap (25) is embodied in the form of a truncated cone and/or the cavity (27) is embodied as a depression in the form of a cylinder stub.

15. Operating apparatus (7) for a cooking appliance (1), with an operating element receptable (8) and a portable operating element (9) according to one of the preceding claims, which can be positioned on and removed from the operating element receptacle (8) in a non-destructive, detachable manner.

## Revendications

1. Élément de commande portatif (9) pour un dispositif de commande (7) pour un appareil de cuisson (1), formé pour une pose non-destructive sur et un retrait non destructif d'un logement d'élément de commande (8) du dispositif de commande (7) et pouvant être actionné à l'état posé pour le réglage de conditions de fonctionnement de l'appareil de cuisson (1), dans lequel l'élément de commande (9) présente une carcasse (17) et un aimant annulaire (28) disposé dans la carcasse (17) et l'élément de commande (9) présente un influenceur de champ magnétique (29) séparé de l'aimant annulaire (28), lequel influenceur est disposé dans la carcasse (17), dans lequel l'influenceur de champ magnétique (29) présente une bague (30) disposée au-dessus de l'aimant annulaire (28) et en chevauchement avec l'aimant annulaire (28) dans le sens radial de l'élément de commande (9), **caractérisé en ce que** l'influenceur de champ magnétique (29) présente en outre au moins une bride (31) disposée sur un bord intérieur (30a) de la bague (30) et orientée axialement vers le bas à la verticale, de sorte qu'elle est disposée en chevauchement avec l'aimant annulaire (28) dans le sens d'un axe longitudinal (A) de l'élément de commande (9).

2. Élément de commande portatif (9) selon la revendication 1, **caractérisé en ce que** plusieurs brides (31) sont présentes, lesquelles sont disposées à équidistance autour de l'axe longitudinal (A) dans le sens périphérique.

3. Élément de commande portatif (9) selon la revendication 2, **caractérisé en ce que** les brides (31) s'étendent respectivement entre 20° et 80° dans le sens périphérique autour de l'axe longitudinal (A).

4. Élément de commande portatif (9) selon l'une des revendications précédentes, **caractérisé en ce que** la bague (30) et l'au moins une bride (31) sont formées en une seule pièce.

5. Élément de commande portatif (9) selon l'une des revendications précédentes, **caractérisé en ce que** l'influenceur de champ magnétique (29) est en un matériau ferromagnétique.

6. Élément de commande portatif (9) selon l'une des revendications précédentes, **caractérisé en ce que** la bague (30) repose directement sur un côté supérieur (28a) de l'aimant annulaire (28) et/ou la bague (30) fait saillie vers l'extérieur au-delà de l'aimant annulaire (28) en direction radiale par rapport à l'axe longitudinal (A).

7. Élément de commande portatif (9) selon l'une des revendications précédentes, **caractérisé en ce que** l'au moins une bride (31) est disposée, en direction radiale par rapport à l'axe longitudinal (A), davantage à l'intérieur que l'aimant annulaire (28) et à distance de l'aimant annulaire (28) en direction radiale.

8. Élément de commande portatif (9) selon l'une des revendications précédentes, **caractérisé en ce que** l'au moins une bride (31) s'étend davantage vers le bas que l'aimant annulaire (28) en direction axiale.

9. Élément de commande portatif (9) selon l'une des revendications précédentes, **caractérisé en ce que** l'aimant annulaire (28) est injecté en un matériau à terres rares lié par matière synthétique ou en ferrite dure liée par matière synthétique.

10. Élément de commande portatif (9) selon l'une des revendications précédentes, **caractérisé en ce que** la carcasse (17) est fermée et présente une partie supérieure de carcasse (18) et une partie inférieure de carcasse (19).

11. Élément de commande portatif (9) selon l'une des revendications précédentes, **caractérisé en ce que** la carcasse (17) présente un côté inférieur (33) formé par sections, en particulier sur une zone extérieure radiale, de façon tronconique.

12. Élément de commande portatif (9) selon l'une des revendications précédentes, **caractérisé en ce que** l'élément de commande (9) présente la carcasse (17) et un élément partiel (22) séparé de la carcasse (17), sur lequel la carcasse (17) est posée et sur lequel la carcasse (17) est déplaçable par rapport à l'élément partiel (22).

13. Élément de commande portatif (9) selon la revendication 12, **caractérisé en ce que** la carcasse (17) présente, sur le côté inférieur (33), une concavité (23) dans laquelle l'élément partiel (22) plonge, dans lequel un toit (24) de la concavité (23) présente une saillie (25) qui s'engrène dans un creux (27) dans un côté supérieur (26) de l'élément partiel (22).

14. Élément de commande portatif (9) selon la revendication 13, **caractérisé en ce que** la saillie (25) est formée de façon tronconique et/ou le creux (27) sous forme de concavité en forme de tronçon cylindrique.

15. Dispositif de commande (7) pour un appareil de cuisson (1), avec un logement d'élément de commande (8) et un élément de commande portatif (9) selon l'une des revendications précédentes, lequel peut être posé de façon amovible non-destructive sur et retiré de façon non destructive du logement d'élément de commande (8).
